# EUROPEAN PATENT SPECIFICATION

(11) **EP 1 761 396 B1**
(45) Date of publication and mention of the grant of the patent: **07.05.2008**
(21) Application number: 05742519.1
(22) Date of filing: 24.05.2005
(51) Int. Cl.: B41M 5/28, B41M 5/26

(54) **PRINTING OF ORGANOMETALLIC COMPOUNDS TO FORM CONDUCTIVE TRACES**
DRUCKEN VON ORGANOMETALLISCHEN VERBINDUNGEN ZUR HERSTELLUNG VON LEITERBAHNEN
IMPRESSION DE COMPOSÉS ORGANOMÉTALLIQUES POUR CONSTITUER DES RUBANS CONDUCTEURS

(30) Priority: 15.06.2004 US 869639
(43) Date of publication of application: 14.03.2007
(73) Proprietor: Hewlett-Packard Development Company, L.P., Houston, TX 77070 (US)
(72) Inventor: CHEN, Qiong, Singapore 119968 (SG); NEO, Jamie, Singapore 1 19968 (SG); CHEN, Peng Blk 1200, Depot Road, 07-01/19, Singapore 109674 (SG); TAN, John Hui Ming, Sinagapore 119968 (SG); BALASUBRAMANIAM, Venkataramanan Blk 1200 Depot, Singapore 109674 (SG)
(74) Representative: Tollett, Ian
(86) International application number: PCT/SG2005/000161
(87) International publication number: WO 2005/123410

(56) References cited:
- EP-A- 0 489 411
- US-A1- 2004 026 258
- US-B1- 6 319 564

## Description

### Field Of The Invention

The present invention relates to printed circuits or devices in the electronics industry, and in particular, to printing of organometallic compounds on a substrate that are used to form conductive traces after exposure to electromagnetic radiation, for example laser light.

### Background Of The Invention

Laser-assisted selective deposition of conductive metals is an attractive approach to the customization needs of the electronics industry. For more than about 20 years much effort has been undertaken in attempting to produce acceptable individual metal features in electronic components or circuits by a direct laser writing process. Normally, a device is prepared for subsequent direct laser writing by a spin-coating process which applies a uniform film over a surface.

Spin-coating is a known process used for applying a thin film, such as a metal, to a substrate in the manufacture of circuits. A typical spin-coating process involves depositing a small puddle of a fluid resin onto the center of the substrate and then spinning the substrate at high speed. However, spin-coating processes generally involve a relatively high cost of materials and a further washing process to remove unwanted material.

Another disadvantage of circuit manufacture by direct laser writing is that the width of a deposited metal trace is limited by thermal effects in the laser beam. Presently, even if a laser beam is focused to a diameter of about 20 µm the achievable minimum trace width is about 40 µm.

Another known circuit manufacture process involves etching. A number of variations of etching methods are known, such as wet etching (whereby material is dissolved when immersed in a chemical solution), and dry etching (whereby material is sputtered or dissolved using reactive ions or a vapor phase etchant). However, these methods have significant disadvantages such as a requirement to use a mask of the desired circuit layout pattern that can withstand the etching process. Generally, etching processes and use of masks are considered relatively expensive and require longer turn around times in the manufacture of circuitry.

US 4,574,095 discloses deposition of copper on a substrate by a process in which small palladium clusters or seeds are first deposited on a substrate. Selective deposition of the palladium seeds is accomplished by contacting the substrate with the vapor of a palladium compound and selectively irradiating the complex with light, which can be a laser. The substrate is first covered with photoresist or polymer and selectively irradiated, through a mask, with a pulsed excimer laser. Removal of the polymer occurs in the irradiated area. The film then acts as a seed for plating of copper. This method requires use of a photoresist and a mask and is a direct laser writing process having the associated disadvantages.

US 4,853,252 discloses transfer of a printed pattern in the manufacture of printed circuit boards. A grainy carrier substance of a coating agent affords a good adhesive foundation in a substrate which is controllable through the use of energy radiation. The coating agent is applied to the surface of the substrate S. A laser is utilized as an energy beam. The focussing of the laser beam L is adjustable, whereby the diameter of the laser beam L at the substrate surface can be set to diameters of between approximately 50 microns to about 400 microns. The coating agent includes individual particles of metal M. The laser beam L is guided over the surface of the substrate S and creates a superficial melting of the substrate. This method requires the conductor pattern to be constructed by chemical metal deposition or by chemical and subsequent galvanic metal deposition and relies on a laser heating process to adhere the coating agent to the substrate.

Accordingly, there is need for a printing system which overcomes or at least ameliorates the above-described problems. The present invention addresses this need.

### SUMMARY OF THE INVENTION

According to one broad form of the present invention, there is provided a method of forming a desired conductive trace layout on a substrate, comprising the steps of: printing an organometallic compound onto the substrate, heating the substrate near or at an interface area of the organometallic compound and the substrate, and, depositing at least part of the conductive trace on the substrate near or at the heated interface area.

This and other objects or advantages of the present invention will no doubt become obvious to those of ordinary skill in the art after having read the following detailed description of the embodiments as illustrated in the drawing figures.

### DESCRIPTION OF THE DRAWINGS

The present invention should become apparent from the following description, which is given by way of example only, of a preferred but non-limiting embodiment thereof, described in connection with the accompanying figures.
Fig. 1 is a schematic illustration of a possible optical system for use as part of an embodiment of the present invention.
Fig. 2A illustrates a cross-sectional view of an example partially formed printed electronic circuit, produced in accordance with an embodiment of the present invention, showing the substrate and organometallic compound.
Fig. 2B illustrates a cross-sectional view of an example printed electronic circuit, obtained from the partially formed printed electronic circuit illustrated in Fig. 2A, produced in accordance with an embodiment of the present invention, showing the substrate, organometallic compound and deposited conductive trace.
Fig. 3 illustrates a flowchart in accordance with an embodiment of the present invention.
Fig. 4 illustrates a possible arrangement of a system to print an organometallic compound onto a substrate according to an embodiment of the present invention.
Fig. 5 illustrates a DBOS image showing a snapshot of the moment drops are ejected from printer nozzles.
Fig. 6 illustrates print-out examples of the organometallic compound used in Fig. 5 and produced by a Hewlett-Packard deskjet printer on a polyimide substrate.
Fig. 7 illustrates an image of a copper trace formed after laser-induced decomposition, according to an embodiment of the present invention, of the organometallic compound used in Figs. 5 and 6.
Fig. 8 illustrates an image of a copper trace formed after electroless plating, according to an embodiment of the present invention, of the copper trace illustrated in Fig. 7.

### DETAILED DESCRIPTION OF THE EMBODIMENTS

In a first broad form of the present invention, there is provided a formulation able to be printed onto a substrate for use in forming a desired conductive trace layout on the substrate, the formulation including at least one organometallic compound dissolved in at least one organic solvent, whereby metal from the organometallic compound is deposited on the substrate when the organometallic compound is heated. In an embodiment, the at least one organic solvent is water-miscible and the organometallic compound is water soluble. The organometallic compound is in the form of at least one of an acetate, carboxylate or amine complex. Furthermore, the organometallic compound contains at least one of silver, gold, aluminium, copper or palladium. Additionally, the organometallic compound can include an organic solvent wherein the organic solvent is at least one of a ketone, pentandiol or triol.

In another embodiment, there is provided a chemical solution able to be printed onto a substrate using an inkjet printer and for use in forming a desired metallic trace layout on the substrate, the chemical solution including at least one organometallic compound dissolved in at least one water-miscible organic solvent, whereby metal from the organometallic compound is deposited on the substrate as a result of heating of the substrate by laser light absorbed near or at an interface between the printed chemical solution and the substrate.

In a third embodiment, there is provided a formulation able to be printed onto a substrate for use in forming a desired conductive trace layout on the substrate. The formulation includes an organometallic compound being less than 50% of the formulation by weight, at least one organic solvent being less than 50% of the formulation by weight and water being more than 50% of the formulation by weight whereby metal from the organometallic compound is deposited on the substrate when the organometallic compound is heated.

In another aspect, inkjet technology is utilised as a microprinting tool. An inkjet printer is used to print organometallic compounds on substrates, such as, but not limited to, glass, polyimide, ceramic, paper, etc. According to this aspect of the invention, a relatively narrow conductive trace width can be achieved, for example, less than or equal to 20 µm. Additionally, the width of the conductive trace is independent from the diameter of a laser beam used to effect deposition of the conductive material, for example, a metal such as copper. By removing the requirement of a mask or a washing process the cost of manufacture of a circuit is significantly reduced. Consequently, the complete circuit manufacture process is simplified and is a cheaper and more convenient dry process.

Furthermore, the total turn around time for the manufacture of a circuit is reduced and the reliability of circuits manufactured by such a dry process is improved. Additionally, a relatively fine or narrow conductive trace width can be achieved without reliance on masks and etching processes.

According to yet another aspect, by precisely controlling the height of deposited conductive material, the remaining thin film of the organometallic compound can be used as a protective layer to prevent the deposited conductive trace layer from oxidising due to contact with the ambient atmosphere.

Environmental advantages are also realized such as a reduction in the amount or type of various chemicals required to be deposed of, and a reduction in the volume of water required during the manufacturing process.

Furthermore, the deposited conductive trace layouts can be used to perform the function of a wide variety of circuits. For example, a radio-frequency identification (RF ID) coil can be manufactured and deposited on a variety of substrates. This leads to a reduction in the cost of manufacturing RF ID coils, as well as an increase in the flexibility to accelerate the design cycle time.

In an embodiment, the organometallic compound is water soluble and includes a metal such as, silver (Ag), gold (Au), aluminium (Al), copper (Cu), or palladium (Pd). The formulation to dissolve the organometallic compound is a mixture of water-miscible organic solvents.

The following examples provide a more detailed discussion of various embodiments of the present invention. The examples are intended to be merely illustrative and not limiting to the scope of the present invention.

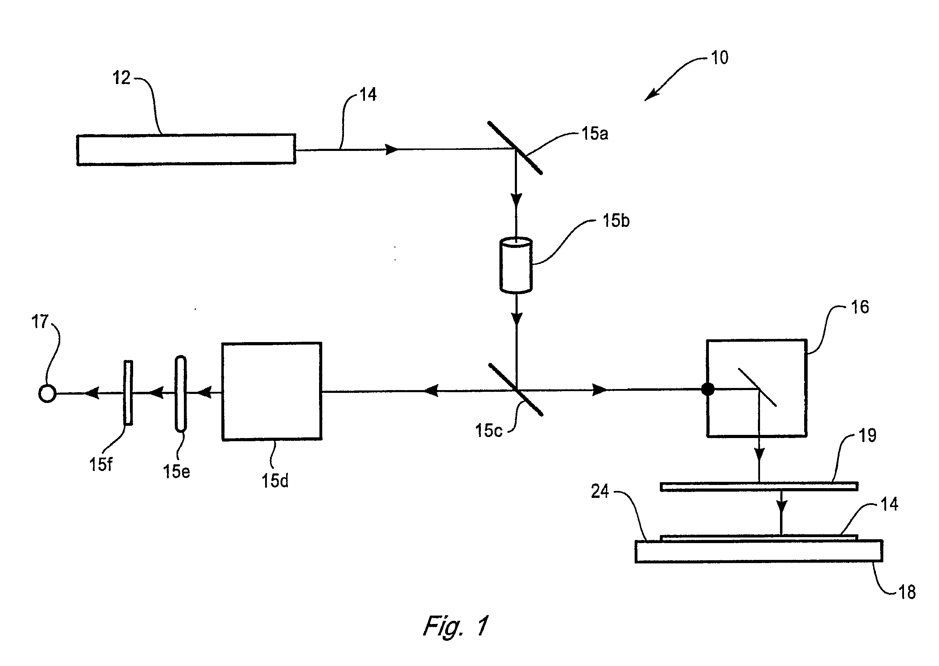

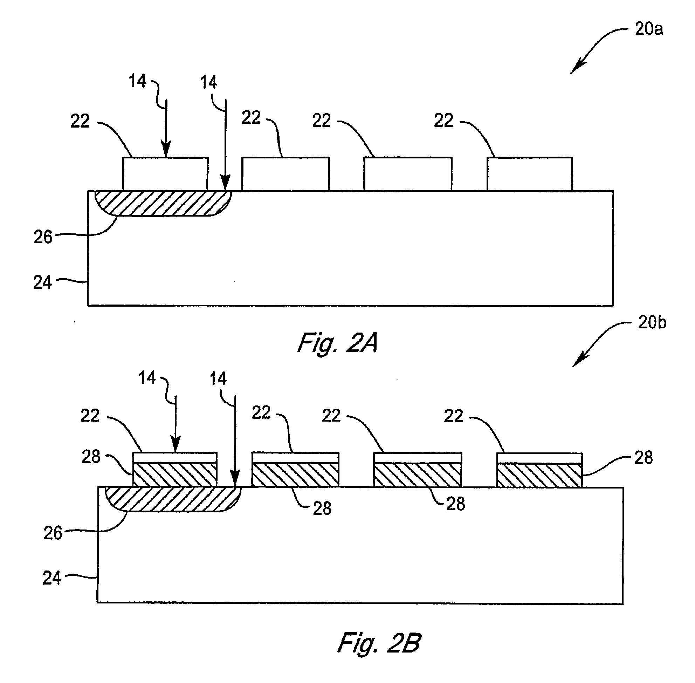

Illustrated in Fig. 1 is a possible, but non-limiting, optical system 10 in accordance with an embodiment. Fig. 2A illustrates a cross-sectional view of an example partially formed printed electronic circuit 20a, produced in accordance with an embodiment of the present invention, showing the substrate 24 and printed organometallic compound 22. Fig. 2B illustrates a cross-sectional view of an example printed electronic circuit 20b, obtained from the partially formed printed electronic circuit 20a illustrated in Fig. 2A, showing the substrate 24, organometallic compound 22 and deposited conductive trace 28. Fig. 2B shows a cross-sectional view of a desired conductive trace layout on a substrate 24 that can be used as an electronic circuit. Referring to Fig. 2A, an organometallic compound is printed as a thin film 22 onto a substrate 24 in the desired conductive trace layout. The organometallic compound is then subjected to irradiation 14 resulting in heating of the substrate 24 illustrated as region 26. Referring to Fig. 2B, heating of thin film 22 subsequently results in separate thin film layers 22 and 28 after irradiation of the printed organometallic compound. The irradiation process results in formation of the conductive layer 28 and original organometallic compound material remains as residual thin film layer 22. A laser source 12 generates a laser light beam 14 that irradiates the organometallic compound 22 (prior to formation of conductive layer 28) and the substrate 24. This results in heating of the substrate 24 near or at an interface area 26 of the organometallic compound 22 and the substrate 24. Consequently, deposition of conductive layer 28 results, being at least part of the desired conductive trace layout, on the substrate 24 near or at the heated interface area 26. This is due to the laser light beam 14 being at least partially absorbed by the substrate 24, or until all the organometallic compound 22 is decomposed.

The laser light beam 14 or the substrate 24 are then moved so that the laser light beam 14 irradiates other interface areas (not illustrated) resulting in deposition of other layers of conductive traces (also shown as layers 28) on the substrate 24 near or at the other interface areas as they are heated. The laser light beam 14 may be scanned over the desired conductive trace layout in any manner that achieves heating of the substrate 24 in all of the desired interface areas between the printed organometallic compound 22 and the substrate 24.

In an embodiment, the organometallic compound is substantially transparent to the laser light so that the laser light beam 14 is substantially transmitted by the printed organometallic compound 22 and is substantially absorbed by the substrate material 24. Different organometallic compounds may react better with different laser light sources 12 producing different wavelengths of laser light.

According to one particular aspect, relative movement of the laser light beam 14 and the substrate 24 can be achieved by moving the laser light beam 14 using a galvanometer 16 and/or moving the substrate 24 using a x-y stage 18. The laser light beam 14 is manipulated by optical components illustrated in Fig. 1. The 45° mirror 15a directs laser light 14 to beam expander 15b which passes the laser light 14 to split mirror 15c, this results in a portion of laser light 14 being directed to galvanometer 16 and another portion of laser light 14 being directed to detector 15d, which detects light and passes laser light 14 to focusing lens 15e which focuses laser light 14 onto screen 15f so that the relative position of the laser light 14 on the substrate 24 can be observed by an observer 17. In one particular embodiment observer 17 may be provided with control electronics able to control parameters of the optical system 10, such as movement of the laser light beam 14 via the galvanometer 16 and an f-theta lens 19 or movement of the substrate 24 via movement of the x-y stage 18. Significantly different optical systems can be employed and fall within the scope of the present invention.

It should be noted that although reference to laser light 14 is made, it is possible that other forms of electromagnetic radiation could be utilised to effectively heat the interface area 26 of the substrate 24. All that is desired is that the electromagnetic radiation can pass through the organometallic compound 22 and release energy in the substrate material 24 to heat the interface region 26.

It should also be noted that it is not essential that organometallic compound layer 22 remains after heating. It is possible, for heating of the organometallic compound to result in complete deposition of available conductive material 28. Hence, no organometallic compound layer 22 would remain overlaying the conductive trace layer 28 after heating.

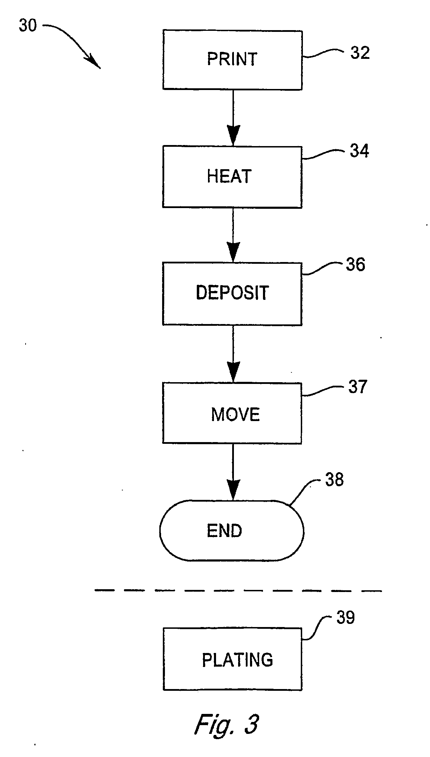

Fig. 3 illustrates the steps of a method 30 according to an embodiment. At step 32 the organometallic compound is printed onto the substrate 24 in the desired conductive trace layout using a printer, for example a Hewlett-Packard thermal inkjet printer. At step 34 heating of the substrate near or at the interface area 26 of the organometallic compound 22 and the substrate 24 occurs using laser light 14. At step 36, as a result of heating of the interface area 26, a conductive trace 28 is deposited on the substrate 24 near or at the heated interface area 26. At step 37 the laser light beam 14 or the substrate 24 are moved so that the laser light beam 14 heats other interface areas between the printed organometallic compound 22 and the substrate 24, thereby resulting in other areas of deposited conductive traces. Steps 34, 36 and 37 are repeated until the desired conductive trace layout is fully formed on the substrate 24, after which method 30 can progress to completion at step 38. Optionally, an additional step 39 of electroless plating can be used to increase the height of the conductive trace 28. This is an optional step according to one possible embodiment, but is not an essential step of the present invention.

In order to increase the adhesion between the conductive layer 28 and the substrate 24, it is advantageous to modify the substrate surface before the printing step 32. This is particularly true when the substrate is made of polyimide. A suitable surface modification treatment for a polyimide substrate includes, in sequence: (a) alkali etching treatment using a conventional alkali, e.g. KOH, NaOH (b) rinsing in water, (c) neutralization in an acidic solution, e.g. HCl-containing solution, (d) rinsing in water, (e) drying in an oven with proper ventilation. The dried substrate is then ready for printing.

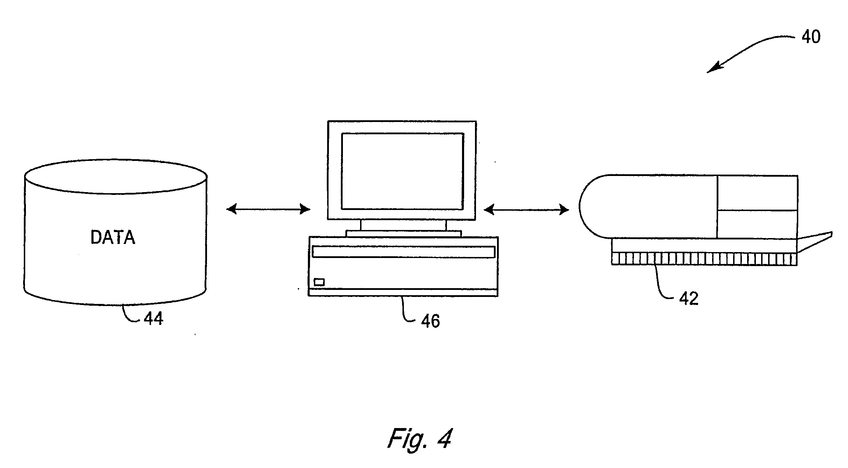

In Fig. 4 is illustrated a system 40 for transmitting a desired conductive trace layout to a printer 42. The desired conductive trace layout may be stored as a data file in database or computer memory 44 which is in communication with computer system 46. An operator of computer system 46 can create a desired conductive trace layout and transmit the desired conductive trace layout to the printer 42 which prints the organometallic compound onto the substrate in the desired conductive trace layout. For example, the desired conductive trace layout may be stored as an Autocad drawing.

Referring back to Figures 1 and 2, the wavelength of the laser light 14 may be 532 nm or 514.5 nm, for example generated by a Nd:YAG laser or Argon laser. When the temperature of the interface between the substrate 24 and the organometallic thin film 22 reaches a threshold temperature, decomposition of the organometallic compound occurs and the conductive metal trace is deposited locally on the surface of the substrate 24. The organometallic compound may be Cu(HCOO)₂.2H₂O. The laser-induced decomposition of this organometallic compound can be described as follows:
i. Cu(HCOO)₂.2H₂O → Cu(HCOO)₂ + 2H₂O
ii. Cu(HCOO)₂ → Cu + H₂ + 2CO₂

The resulting hydrogen (H₂) and carbon dioxide (CO₂) can be absorbed by an exhaust system to capture these by-product gases. The metallic trace is deposited copper (Cu). In one form, the printer is a thermal inkjet printer, for example the Hewlett-Packard deskjet printer. Other types of inkjet printers may be used, for example a piezo inkjet printer.

It is possible that the thickness of the conductive trace 28 may not satisfy the conductivity requirement for certain electronic products. As such, it is possible to use electroless plating as an additional step in order to build up a thicker conductive trace layer 28. For example, the conductive trace layer can be built up to a height of about 1 to 3 µm.

An electroless plating step may utilise the same type of metal deposited from the organometallic compound or a different type of metal, for example combinations such as copper and copper, copper and gold, copper and palladium, etc, are possible. Any circuit that can be printed on a particular substrate can be produced according to the above-described embodiments.

If the quantity or height of deposited conductive trace 28 is precisely controlled by the level of heating at the interface 26, then a thin layer of organometallic compound 22 can be allowed to remain and overlay the deposited metal 28. This can be desirable as the remaining organometallic compound film 22 can provide a protective layer to prevent the underlying conductive layer 28 from oxidising in ambient air.

According to another aspect, a radio-frequency identification (RF ID) coil can be manufactured according to the present invention. The current process to produce a RF ID coil in the prior art includes chemical etching and CNC milling. This prior art technique includes significant problems, for example: higher costs due to waste of copper material, higher costs due to disposing of the chemical acid solution, higher costs due to specialised equipment requirements, environmental disadvantages that may result from the improper disposing of waste materials such as copper and contaminated water, and a longer design cycle time due to the requirement to design masks.

By using a normal inkjet printer with a suitable organometallic compound, such as a copper formate, once the RF ID coil design has been prepared, the design can be promptly printed onto any desired and suitable substrate. A Nd:YAG laser with a wavelength of 532 nanometres can be used to decompose the copper formate so as to form a copper trace layout that is the same as the designed RF ID coil printed on the substrate. A wide variety of substrates can be used such as glass, plastics, ceramics, paper, etc. Such a process leads to significant cost savings, is more environmental friendly, and allows faster design times and circuit prototyping.

According to yet another embodiment, an organometallic compound that can be utilised as part of an inkjet formulation that can be introduced into a printer cartridge. In order to achieve proper drop ejection of the solution (i.e. formulation) from printer nozzles, physical properties of the solution should be optimized, such as the surface tension and viscosity of the solution. Quality drops from nozzles translate into quality conductive traces.

In order to achieve a higher density of organometallic compound on a substrate after each print, higher concentration of organometallic compound is desired. However, this can pose a challenge when considering solubility of the organometallic compound in solution when printing. The higher the concentration of the organometallic compound, the higher the tendency that burnt residues may be left over on the heater surface after printing. The presence of residue will degrade the quality and stability of subsequent drops. Hence, the type of solvents and their concentrations need to be optimized.

The formulation contains at least one water soluble organometallic compound. The organometallic compound can be in the form of an acetate, carboxylate or an amine complex. The metal component of the organometallic compound can include silver (Ag), gold (Au), aluminium (Al), copper (Cu), and/or palladium (Pd). The vehicle to dissolve the organometallic compound may include at least one water-miscible organic solvent such as nitrogen-containing ketones (e.g. 2-pyrrolidone, N-methyl-pyrrolid-2-one (NMP)), pentandiols (e.g. 1,2-pentandiol, 1,5-pentandiol) and/or triols (e.g. glycerol).

A specific example provided below in Table 1 however, numerous other organometallic compounds and inkjet formulations are possible.

**Table 1**

| **Component** | **WL %** |
|---|---|
| Cu formate hydrate, Cu(HCOO)₂ 2H₂O | 9 |
| Triol | 15 |
| Diol | 8 |
| Nitrogen heterocyclic ketone | 7.5 |
| Balance water | 60.5 |
| Total | 100 |
| | |

| Solubility | Clear blue |
|---|---|
| pH | 4.87 |
| Viscosity(centipoise) | 2.77 |
| Surface tension (dye/cm) | 50.7 |
| Conductivity (mmho/cm) (i.e. "milli-Ohms per cm") | 4.46 |
| DBOS Observation | • Nozzles can continue firing |
| | • Straight drops. |
| | • Able to have multiple fires (i.e. on/off/on/off etc.) |
| | • No puddling |
| | • No crystal formation on orifice plate surface |

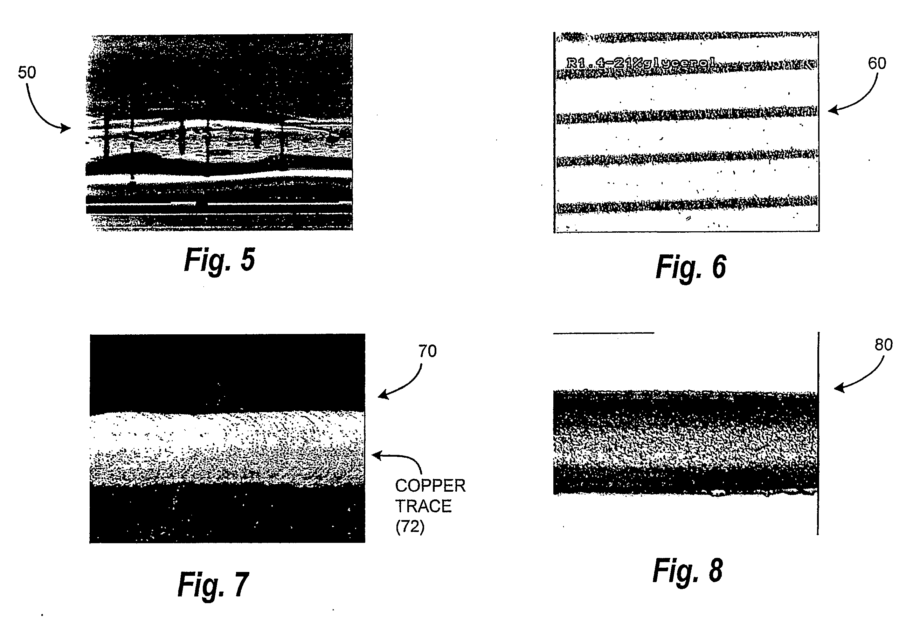

It should be noted with reference to Table 1 that DBOS ("Drop Break-off Observation System") is a tool used to observe drops fired from inkjet cartridge nozzles. A DBOS image 50 shows a snapshot of the moment drops are ejected from the nozzles, as illustrated in Fig. 5. A Hewlett-Packard deskjet 6122 was used to generate a printout on a substrate. The substrate used was normal printing paper and polyimide film treated by oxygen plasma ash before use. An image of the printed example 60 generated by the deskjet printer is illustrated in Fig. 6. Shown in Fig. 7 is an image 70 of a copper trace 72 formed after laser-induced decomposition, as previously described. Shown in Fig. 8 is an image 80 of a copper trace formed after optional electroless plating of the copper trace illustrated in Fig. 7.

It is demonstrated that the inkjet formulation presented in Table 1 can be printed by a thermal inkjet printer with acceptable quality. Thus, following the aforementioned laser-induced decomposition process a conductive copper trace 72 was deposited on a substrate after printing of a formulation containing an organometallic compound by thermal ink jet printing.

Hence, there has been provided a formulation for printing organometallic compounds for use in forming conductive traces on substrates.

## Claims

1. A method of forming a desired conductive trace layout on a substrate, comprising the steps of:
printing a formulation containing an organometallic compound onto the substrate in the desired conductive trace layout using an inkjet printer, the organometallic compound substantially transparent to electromagnetic radiation which is at least in part absorbed by the substrate;
heating the substrate near or at an interface area of the organometallic compound and the substrate using the electromagnetic radiation; and,
depositing the conductive trace on the substrate near or at the heated interface area as a result of the heating step,
wherein the formulation comprises, in weight percentage based on the total weight of the formulation:
(i) less than 50% by weight of an organometallic compound, said organometallic compound contains at least one of silver, gold, aluminum, copper or palladium;
(ii) less than 50% by weight of a water-miscible organic solvent selected from a group consisting of ketones, pentandiols, triols, and mixtures thereof; and
(iii) more than 50% by weight of water.

2. The method as claimed in claim 1, wherein the electromagnetic radiation is moved to heat other interface areas to deposit the desired conductive trace layout.

3. The method as claimed in claim 1, wherein the substrate is moved to heat other interface areas to deposit the desired conductive trace layout.

4. The method as claimed in claim 1, wherein the electromagnetic radiation is a laser light beam.

5. The method as claimed in claim 4, wherein the width of a conductive trace is independent of the diameter of the laser light beam.

6. The method as claimed in claim 1, wherein the normal width of a conductive trace is less than about 40 µm.

7. The method as claimed in claim 1, wherein the normal width of a conductive trace is less than about 20 µm.

8. The method as claimed in claim 1, wherein a protective anti-oxidation layer overlays the conductive trace deposited on the substrate as an optional result of the deposition step.

9. The method as claimed in claim 1, wherein an additional step of electroless plating is utilised to increase the height of the conductive trace.

10. The method as claimed in claim 1, wherein the desired conductive trace layout forms a radio-frequency identification coil.

11. The method as claimed in claim 1 further comprises a surface modification treatment prior to printing in order to improve the adhesion between the substrate and the conductive trace.

12. The method as claimed in claim 11, wherein the surface modification treatment comprises, in sequence, the steps of:
(a) alkali etching treatment using an alkali-containing solution;
(b) rinsing in water;
(c) neutralization in an acidic solution;
(d) rinsing in water;
(e) drying.

## Patentansprüche

1. Ein Verfahren zum Bilden eines gewünschten Layouts einer leitfähigen Spur auf einem Substrat, das folgende Schritte aufweist:
Drucken einer Formel, die eine organometallische Verbindung enthält, auf das Substrat in dem gewünschten Layout einer leitfähigen Spur unter Verwendung eines Tintenstrahldruckers, wobei die organometallische Verbindung im Wesentlichen transparent für elektromagnetische Strahlung ist, die zumindest teilweise durch das Substrat absorbiert wird;
Erwärmen des Substrats in der Nähe oder an dem Schnittstellenbereich der organometallischen Verbindung und des Substrats unter Verwendung der elektromagnetischen Strahlung; und
Aufbringen der leitfähigen Spur auf das Substrat in der Nähe oder an dem erwärmten Schnittstellenbereich als Folge des Erwärmungsschrittes,
wobei die Formel in Gewichtsprozent basierend auf dem Gesamtgewicht der Formel folgendes aufweist:
(i) weniger als 50 Gewichtsprozent einer organometallischen Verbindung, wobei die organometallische Verbindung zumindest entweder Silber, Gold, Aluminium, Kupfer oder Palladium enthält;
(ii) weniger als 50 Gewichtsprozent eines wassermischbaren organischen Lösungsmittels, das aus einer Gruppe ausgewählt ist, die aus Ketonen, Pentandiolen, Triolen und Mischungen derselben besteht; und
(iii) mehr als 50 Gewichtsprozent Wasser.

2. Das Verfahren gemäß Anspruch 1, bei dem die elektromagnetische Strahlung bewegt wird, um andere Schrittstellenbereiche zu erwärmen, um das gewünschte Layout einer leitfähigen Spur aufzubringen.

3. Das Verfahren gemäß Anspruch 1, bei dem das Substrat bewegt wird, um andere Schnittstellenbereiche zu erwärmen, um das gewünschte Layout einer leitfähigen Spur aufzubringen.

4. Das Verfahren gemäß Anspruch 1, bei dem die elektromagnetische Strahlung ein Laserlichtstrahl ist.

5. Das Verfahren gemäß Anspruch 4, bei dem die Bereite einer leitfähigen Spur unabhängig von dem Durchmesser des Laserlichtstrahls ist.

6. Das Verfahren gemäß Anspruch 1, bei dem die normale Breite einer leitfähigen Spur weniger als ungefähr 40 µm ist.

7. Das Verfahren gemäß Anspruch 1, bei dem die normale Breite einer leitfähigen Spur weniger als ungefähr 20 µm ist.

8. Das Verfahren gemäß Anspruch 1, bei dem eine schützende Antioxidationsschicht die leitfähige Spur überlagert, die auf dem Substrat aufgebracht ist, als ein optionales Ergebnis des Aufbringungsschrittes.

9. Das Verfahren gemäß Anspruch 1, bei dem ein zusätzlicher Schritt des stromlosen Plattierens eingesetzt wird, um die Höhe der leitfähigen Spur zu erhöhen.

10. Das Verfahren gemäß Anspruch 1, bei dem das gewünschte Layout einer leitfähigen Spur eine Hochfrequenzidentifikationsspule bildet.

11. Das Verfahren gemäß Anspruch 1, das ferner eine Oberflächenmodifikationsbehandlung vor dem Drucken aufweist, um die Haftung zwischen dem Substrat und der leitfähigen Spur zu verbessern.

12. Das Verfahren gemäß Anspruch 11, bei dem die Oberflächenmodifikationsbehandlung in dieser Reihenfolge folgende Schritte aufweist:
(a) Alkaliätzbehandlung unter Verwendung einer Alkali enthaltenden Lösung;
(b) Spülen in Wasser;
(c) Neutralisieren in einer Säurelösung;
(d) Spülen in Wasser;
(e) Trocknen.

## Revendications

1. Procédé de formation d'un tracé d'une ligne conductrice souhaitée sur un substrat, comprenant les étapes consistant à :
imprimer une formulation contenant un composé organométallique sur le substrat sur le tracé d'une ligne conductrice souhaitée à l'aide d'une imprimante par jet d'encre, le composé organométallique étant pratiquement transparent à un rayonnement électromagnétique qui est au moins en partie absorbé par le substrat ;
chauffer le substrat à proximité ou au niveau d'une zone d'interface du composé organométallique et du substrat à l'aide du rayonnement électromagnétique ; et
déposer la ligne conductrice sur le substrat à proximité ou au niveau de la zone d'interface chauffée suite à l'étape de chauffage,
dans lequel la formulation comprend, en pourcentage en poids par rapport au poids total de la formulation :
(i) moins de 50 % en poids d'un composé organométallique, ledit composé organométallique contenant au moins un élément parmi l'argent, l'or, l'aluminium, le cuivre ou le palladium ;
(ii) moins de 50 % en poids d'un solvant organique miscible avec l'eau choisi dans le groupe constitué par les cétones, les pentanediols, les triols et les mélanges de ceux-ci ; et
(iii) plus de 50 % en poids d'eau.

2. Procédé selon la revendication 1, dans lequel le rayonnement électromagnétique est déplacé de façon à chauffer d'autres zones d'interface de façon à déposer le tracé d'une ligne conductrice souhaitée.

3. Procédé selon la revendication 1, dans lequel le substrat est déplacé de façon à chauffer d'autres zones d'interface de façon à déposer le tracé d'une ligne conductrice souhaitée.

4. Procédé selon la revendication 1, dans lequel le rayonnement électromagnétique est un faisceau de lumière d'un laser.

5. Procédé selon la revendication 4, dans lequel la largeur de la ligne conductrice est indépendante du diamètre du faisceau de lumière du laser.

6. Procédé selon la revendication 1, dans lequel la largeur normale d'une ligne conductrice est inférieure à environ 40 µm.

7. Procédé selon la revendication 1, dans lequel la largeur normale d'une ligne conductrice est inférieure à environ 20 µm.

8. Procédé selon la revendication 1, dans lequel une couche anti-oxydation protectrice recouvre la ligne conductrice déposée sur le substrat suite éventuellement à l'étape de dépôt.

9. Procédé selon la revendication 1, dans lequel une étape supplémentaire d'un placage sans courant est utilisée pour augmenter la hauteur de la ligne conductrice.

10. Procédé selon la revendication 1, dans lequel le tracé d'une ligne conductrice souhaitée forme un serpentin d'identification par radiofréquence.

11. Procédé selon la revendication 1, qui comprend en outre un traitement de modification de surface avant l'impression afin d'améliorer l'adhérence entre le substrat et la ligne conductrice.

12. Procédé selon la revendication 11, dans lequel le traitement de modification de surface comprend, en séquence, les étapes de :
(a) traitement de décapage alcalin à l'aide d'une solution contenant une base;
(b) rinçage avec de l'eau ;
(c) neutralisation avec une solution acide ;
(d) rinçage avec de l'eau ;
(e) séchage.
